# EUROPEAN PATENT SPECIFICATION

(11) **EP 2 355 158 B1**
(45) Date of publication and mention of the grant of the patent: **26.04.2017**
(21) Application number: 11000710.1
(22) Date of filing: 28.01.2011
(51) Int. Cl.: H01L 29/778, H01L 29/205, H01L 29/43, H01L 29/201, H01L 29/51

(54) **Field effect transistor with conduction band electron channel and uni-terminal response**
Feldeffekttransistor mit Leitungsbandelektronenkanal und uni-poliger Antwort
Transistor à effet de champ avec canal d'électrons de bande de conduction et réponse uni-terminale

(30) Priority: 10.02.2010 US 303025 P; 21.12.2010 US 974954
(43) Date of publication of application: 10.08.2011
(73) Proprietor: Taiwan Semiconductor Manufacturing Co., Ltd., Hsin-Chu, 300-77 (TW)
(72) Inventor: Passlack, Matthias, 3060 Bertem (BE)
(74) Representative: Ter Meer Steinmeister & Partner

(56) References cited:
- US-A- 4 163 237
- US-A- 5 349 214
- YANG M J ET AL: "A novel semimetallic quantum well FET", ELECTRON DEVICES MEETING, 1995., INTERNATIONAL WASHINGTON, DC, USA 10-13 DEC. 1995, NEW YORK, NY, USA,IEEE, US, 10 December 1995 (1995-12-10), pages 375-378, XP010161051, DOI: 10.1109/IEDM.1995.499218 ISBN: 978-0-7803-2700-9
- YOH K ET AL: "MOLECULAR BEAM EPITAXIAL GROWTH OF INAS/GASB DOUBLE QUANTUM WELLS FOR COMPLEMENTARY HETEROJUNCTION FIELD-EFFECT TRANSISTORS", JOURNAL OF CRYSTAL GROWTH, ELSEVIER, AMSTERDAM, NL, vol. 127, no. 1/04, 2 February 1993 (1993-02-02), pages 29-35, XP000441046, ISSN: 0022-0248, DOI: 10.1016/0022-0248(93)90571-D
- LI X ET AL: "High-breakdown-voltage AlSbAs/InAs n-channel field-effect transistors", IEEE ELECTRON DEVICE LETTERS, IEEE SERVICE CENTER, NEW YORK, NY, US, vol. 13, no. 4, 1 April 1992 (1992-04-01), pages 192-194, XP011409586, ISSN: 0741-3106, DOI: 10.1109/55.145017

## Description

### BACKGROUND

The present disclosure relates to field effect transistors ("FETs") with uni-terminal response, and more specifically to a common epitaxial layer structure that forms channels comprising conduction band electrons for both positive and negative gate bias for use in FETs with both n-and p-terminal characteristics.

Traditional complementary metal-oxide semiconductor ("CMOS") technology utilizes conduction band electrons to form the conducting channel in devices with n-terminal characteristics and valence band electrons (holes) in devices with p-terminal characteristics. The terminal characteristics of n-channel and p-channel devices are referred to as "complementary". When such complementary devices are connected in series, they form a basic logic gate, or an inverter. This basic complementary design has dominated digital electronics for decades because of its simplicity and low power dissipation; however, the performance of devices with p-channel characteristics is inferior to devices with n-channel characteristics because valence band electrons, or holes, exhibit substantially less mobility than conduction band electrons. This limits the performance of CMOS inverters.

Prior art has described the formation of a conducting channel utilizing conduction band electrons for both devices with p- and n-terminal characteristics (*see, e.g.,* U.S. Patent No. 5,355,005). However, each type of device uses its own epitaxial layer structure, which complicates manufacture and increases costs.

YANG M J ET AL: "A novel semimetallic quantum well FET", ELECTRON DEVICES MEETING, 1995., INTERNATIONAL WASHINGTON, DC, USA 10-13 DEC. 1995, NEW YORK, NY, USA, IEEE, US, 10 December 1995, pages 375-378, XP010161051 discloses a semimetallic quantum well FET that can be, e.g., used as a microwave frequency-doubler. The semimetallic quantum well FET comprises a 1µm GaSb and a 1µm AlSb buffer, followed by a 50nm AlSb bottom barrier, a 14nm InAs quantum well, a 4nm GaSb quantum well, together forming the semimetallic quantum well, a 50nm AlSb top barrier and a 3nm GaSb cap layer to prevent AlSb from oxidation. Next, a 100nm to 200nm silicon oxide dielectric is deposited, followed by a front-gate deposition. Herein, the Fermi level is pinned above the InAs conduction band minimum and non-alloying ohmic contacts are defined by evaporating metal on top of the InAs quantum well after removal of oxide and top layers.

US 5,349,214 A discloses a complementary heterojunction device being formed on a supporting substrate structure including a supporting substrate, a buffer layer to insure that subsequent layers are compatible with the underlying substrate, and a first barrier layer to provide an adequate barrier or energy band width to prevent the leakage of carriers into the buffer layer. A first semiconductive layer is deposited on the upper surface of the first barrier layer, a second barrier layer is deposited on the upper surface of the first semiconductive layer and a second semiconductive layer is deposited on the second barrier layer. On the second semiconductive layer, a cap structure is deposited that includes a third barrier layer, a first cap layer and a second cap layer. In a first area, a first source electrode and a first drain electrode are selectively deposited on the first cap layer and a first gate electrode is deposited on the second cap layer to define a first transistor having a first conduction channel in the second semiconductive layer formed from n-type material. The second cap layer overlying the first conduction channel pins the Fermi level therein such that its number of carriers is substantially less than in the surrounding second semiconductive layer. Further, the first cap layer overlying the surrounding second semiconductive layer pins the Fermi level in the second semiconductive layer surrounding the first conduction channel in a position to enhance the number of carriers therein to provide low resistance access regions connecting the first source and drain electrodes to the first conduction channel. In an area, a second source electrode and a second drain electrode are selectively deposited on the second semiconductive layer and a second gate electrode is deposited on the first cap layer to define a second transistor having a second conduction channel in the first semiconductive layer formed from p-type material. The first cap layer overlying the second conduction channel pins the Fermi level therein such that its number of carriers is substantially less than in the surrounding first semiconductive layer. Further, the second semiconductive layer overlying the surrounding first semiconductive layer pins the Fermi level in the first semiconductive layer surrounding the second conduction channel in a position to enhance the number of carriers therein to provide low resistance access regions connecting the second source and drain electrodes to the second conduction channel. Accordingly, the number of carriers in the conduction channels formed of n-type material and p-type material, respectively, is small so that, with no bias applied to the gate electrodes, a source-drain current flow is prevented in the transistors.

YOH ET AL: "MOLECULAR BEAM EPITAXIAL GROWTH OF InAs/GaSb DOUBLE QUANTUM WELLS FOR COMPLEMENTARY HETEROJUNCTION FIELD-EFFECT TRANSISTORS", JOURNAL OF CRYSTAL GROWTH; ELSEVIER, AMSTERDAM, NL, vol. 127, no 1/04, 2 February 1993, pages 29-35, XP000441046 discloses a complementary hetereojunction FET device comprising an undoped GaAs substrate, a 2µm AlSb buffer layer, a 200nm (Al_{0.5}Ga_{0.5})Sb bottom barrier layer, a 15nm GaSb channel layer, a 6 to 28nm (Al_{0.5}Ga_{0.5})Sb middle barrier layer, a 15nm InAs channel layer, a 15nm (Al_{0.5}Ga_{0.5})Sb top barrier layer and a 10nm GaSb cap layer. To form separate p-channel FET and n-channel FET regions, device isolation is accomplished by etching down to the middle of the (Al_{0.5}Ga_{0.5})Sb bottom barrier layer. In the p-channel region, the (Al_{0.5}Ga_{0.5})Sb top barrier layer and the GaSb cap layer are etched, AuGe alloy is deposited for source and drain contacting of the GaSb p-channel layer, and a portion of the InAs layer is etched to provide gate contacting by Ti/Au deposition. In the n-channel region, portions of the (Al_{0.5}Ga_{0.5})Sb top barrier layer and the GaSb cap layer are etched and filled by Ti/Au depositon to provide source and drain contacts for the InAs n-channel layer, and a portion of the GaSb cap layer is etched and filled by Ti/Au deposition for gate contacting.

### SUMMARY

It is an object of the present invention to provide a complementary inverter circuit comprising two uni-terminal devices connected in series. This object is solved by the inverter circuit according to claim 1.

An inverter circuit comprises an n-channel transistor with n-terminal characteristics comprising a first semiconductor layer having a first discrete hole level H₀; a second semiconductor layer having a conduction band minimum E_{C2}; a first wide bandgap semiconductor barrier layer disposed between the first and the second semiconductor layers; a first gate dielectric layer disposed above the first semiconductor layer; and a first gate metal layer disposed above the first gate dielectric layer and having a first effective workfunction selected to position the first discrete hole level H₀ below the conduction band minimum E_{c2} for zero bias applied to the first gate metal layer and to obtain n-terminal characteristics. The n-channel transistor with n-terminal characteristics further comprises a first set of extensions having n-type conductivity. The inverter circuit further comprises an n-channel transistor with p-terminal characteristics comprising a third semiconductor layer having a second discrete hole level H₀; a fourth semiconductor layer having a second conduction band minimum E_{C2}; a second wide bandgap semiconductor barrier layer disposed between the third and fourth semiconductor layers; a second gate dielectric layer disposed above the third semiconductor layer; and a second gate metal layer disposed above the second gate dielectric layer and having a second effective workfunction selected to position the second discrete hole level H₀ below the second conduction band minimum E_{c2} for zero bias applied to the second gate metal layer and to obtain p-terminal characteristics. The n-channel transistor with p-terminal characteristics further comprises a second set of extensions having n-type conductivity.

### BRIEF DESCRIPTION OF THE DRAWINGS

Fig. 1 illustrates a layer structure used in a uni-terminal transistor comprised in one embodiment.
Fig. 2 is a more detailed illustration of the layer structure shown in Fig. 1.
Fig. 3 is a calculated band diagram illustrating the relative energy levels of the layer structure shown in Fig. 2 in thermal equilibrium (bias = 0 V).
Fig. 4 is a calculated energy band diagram of the layer structure shown in Fig. 2 under a bias of -0.1 V applied to a gate electrode thereof.
Fig. 5 illustrates the calculated electron sheet carrier density in the InAs layer nₛ as a function of gate bias V for the layer structure shown in Fig. 2.
Fig. 6 illustrates the calculated InAs sheet electron concentration in off-state vs. on-state for different InAs layer thickness for p-terminal operation of the layer structure shown in Fig. 2 with SR = nₒₙ/n_{off} as a parameter.
Fig. 7 illustrates a MOSFET fabricated using the layer structure of Fig. 2.
Fig. 8 illustrates a complementary inverter circuit comprising two uni-terminal devices connected in series fabricated using the layer structure of Fig. 2.
Fig. 9 illustrates channel electron charge vs. input voltage of the p- and n-terminal devices for the on-state of the inverter circuit of Fig. 8.
Fig. 10 illustrates channel electron charge vs. input voltage of the p- and n-terminal devices for the off-state of the inverter circuit of Fig. 8.

### DETAILED DESCRIPTION

Aspects of the present disclosure are best understood from the following detailed description when read with the accompanying figures. It is emphasized that, in accordance with the standard practice in the industry, various features are not drawn to scale. In fact, the dimensions of the various features may be arbitrarily increased or reduced for clarity of discussion. Furthermore, the following description shows two or more layers in contact with each other. Such contact can be direct physical contact, or there may be an intervening layer and the contact is indirect, such as through indirect coupling.

The embodiments described herein provide an inverter circuit comprising two transistors in which the conducting channel is formed with conduction band electrons for both devices with p- and n-terminal characteristics using a common and simple semiconductor layer structure; that is, a uni-terminal device.

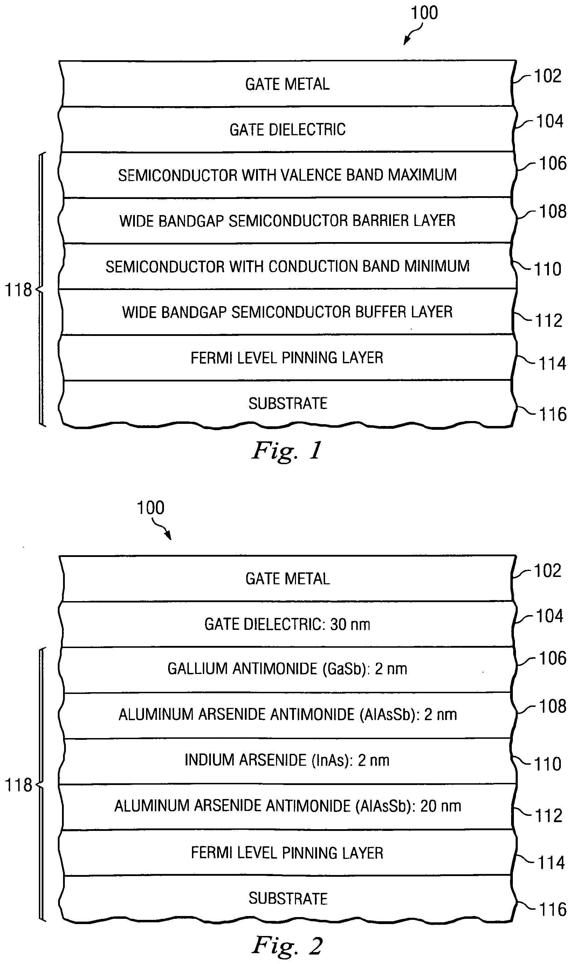

A layer structure used in a uni-terminal transistor comprised in one embodiment is shown in Fig. 1 and designated by a reference numeral 100. The layer structure 100 comprises a gate metal layer 102, a gate dielectric layer 104, a first semiconductor layer with a valence band maximum 106, a wide bandgap semiconductor barrier layer 108, a second semiconductor channel layer with a conduction band minimum 110, a wide bandgap semiconductor buffer layer 112, a Fermi level pinning layer 114, and a substrate 116. The gate metal layer 102 comprises a metal having an appropriate effective workfunction, as will be described in greater detail below. The material comprising the first semiconductor layer with the valence band maximum 106 is selected such that the valence band maximum Eᵥ₁ is located in the vicinity of the conduction band minimum E_{c2} of the material comprising the second semiconductor layer with the conduction band minimum 110. The Fermi level pinning layer 114 pins the Fermi level at the backside of the structure 100 at an appropriate energy position, as will be described in greater detail below. Layers 106-116 are collectively designated by a reference numeral 118.

Fig. 2 is a more detailed illustration of the layer structure 100. As shown in Fig. 2, the wide bandgap barrier and buffer layers 108 and 112 comprise AlAsSb, the first semiconductor layer 106 comprises GaSb, the second semiconductor channel layer 110 comprises InAs. For the selected materials, E_{V1} = -4.79 eV and E_{C2} = -4.9 eV. The Fermi level pinning layer 114 can comprise a wide bandgap semiconductor layer with a discrete energy level inside its bandgap, an interface of high defectivity, or a Schottky contact with appropriate barrier height.

In one embodiment, the gate dielectric layer 104 may comprise hafnium oxide (HfO₂) having a thickness of approximately 30nm. In the same or another embodiment, the gate metal layer 102 may comprise one of tantalum nitride (TaN), titanium nitride (TiN), tungsten (W), tantalum (Ta), molybdenum (Mo), and ruthenium (Ru), among others. It will be recognized that regulation of the effective workfunctions of the foregoing metals may be may be accomplished via adjustment of process conditions to achieve the desired effective workfunction for the intended purpose, as described below.

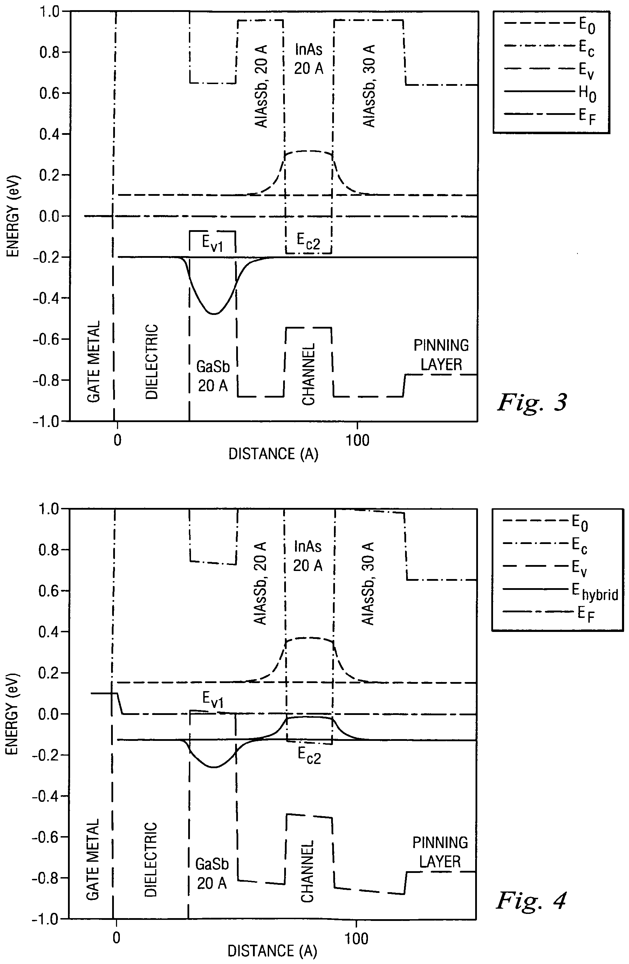

Fig. 3 is a calculated band diagram illustrating the relative energy levels of the uni-terminal device layer structure depicted in Fig. 2 in thermal equilibrium (bias = 0 V). The Fermi level E_{F} is positioned at an absolute energy of -4.72 eV (relative energy 0 eV) using the Fermi level pinning layer 114. Flatband condition is obtained by selecting a metal with an effective workfunction Φₘ of 4.72 eV, which equals the Fermi level pinning position. In equilibrium and at zero bias, the discrete GaSb energy level H₀ shown with its wavefunction Ψ_{Ho} (heavy or light hole level) is positioned below the InAs conduction band minimum E_{c2}. Since the discrete InAs energy level E₀ shown with its wavefunction Ψ_{Eo} (electron ground level) is located substantially above E_{F}, the transistor is off and the electron sheet carrier concentration nₛ in the InAs channel layer is low. In the case shown in Fig. 3, nₛ = 7.3x10⁹ cm⁻².

Fig. 4 is a calculated energy band diagram of the uni-terminal device layer structure depicted in Fig. 2 under a bias of -0.1 V applied to the gate electrode. The hybrid state E_{hybrid} (shown with its wavefunction Ψ_{hybrid}) is formed, which is situated substantially below E_{F} and gives rise to an electron density nₒₙ = 2.9x10¹² cm⁻² in the conduction band of the InAs channel layer. Switching is assumed to occur almost instantaneously at the switch voltage Vₛ when the hybrid state forms under appropriate gate bias. Vₛ is somewhat above - 0.1 V and is set equal to -0.1 V here for purposes of simplicity. Immediately before the hybrid state forms, the layer structure is off with n_{off} = 1.6x10⁹ cm⁻² in the InAs channel layer conduction band, resulting in a switching ratio SR = nₒₙ/n_{off} = 1.84x10³.

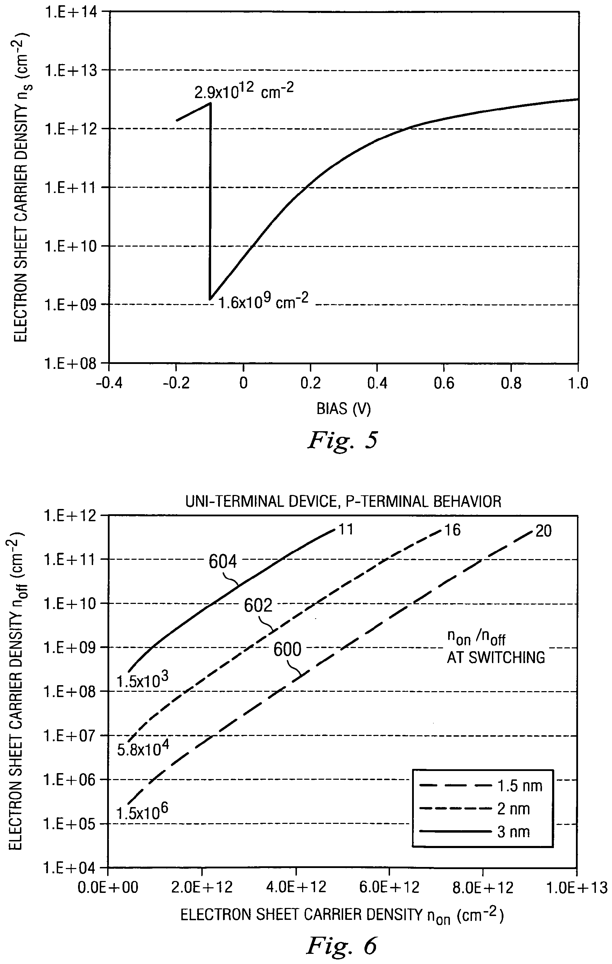

Fig. 5 illustrates the calculated electron sheet carrier density in the InAs channel layer nₛ as a function of gate bias V for the uni-terminal device in accordance with the embodiment illustrated in Fig. 2. As previously described with reference to Figs. 3-4, the electron channel in the InAs layer 110 turns on when the gate bias is lowered from 0 V to - 0.1 V, resulting in p-terminal characteristics. The gate voltage at threshold (threshold voltage Vₜ) in p-terminal operation of the device is equal to the switch voltage Vₛ = -0.1 V. The formation of the hybrid state essentially acts as a dramatic electron density booster carrying the device almost immediately to high non. This is a desirable property for a "millivolt switch," as is the high SR for the uni-terminal layer structure shown in Fig. 2 in p-terminal operation. Switching may also not be as abrupt as indicated because of lateral inhomogenities in layer thickness, composition, etc. Further, illustrated in Fig. 5, the layer structure 100 (Fig. 2) operates in standard n-terminal mode with a positive Vₜ when the gate bias is increased above 0 V. Consequently, the uni-terminal layer structure 100 (Fig. 2) can operate with p-and n-terminal characteristics for negative and positive gate voltage, respectively. In both cases, the conducting channel is formed by conduction band electrons in the InAs channel layer 110.

Fig. 6 illustrates the calculated InAs sheet electron concentration in off-state vs. on-state for different InAs layer thickness for p-terminal operation of the uni-terminal layer structure 100 (Fig. 2) with SR = nₒₙ/n_{off} as a parameter. In particular, a line 600 corresponds to an InAs layer thickness of 1.5 nm (SR=1.5x10⁶), a line 602 corresponds to an InAs layer thickness of 2.0 nm (SR=5.8x10⁴), and a line 604 corresponds to an InAs layer thickness of 3.0 nm (SR=1.5x10³). Higher SR can be obtained with smaller InAs layer thickness. The lowest nₒₙ shown for all curves is 4.3x10¹¹ cm⁻². SR falls with higher nₒₙ. A correct calculation of the hybridized state is expected to lead to nₒₙ values (and simultaneously n_{off} values) that are higher by a factor of up to 3 due to higher unified effective mass and nonparabolicity. On the other hand, the resulting electric field may substantially reduce nₒₙ values and SR.

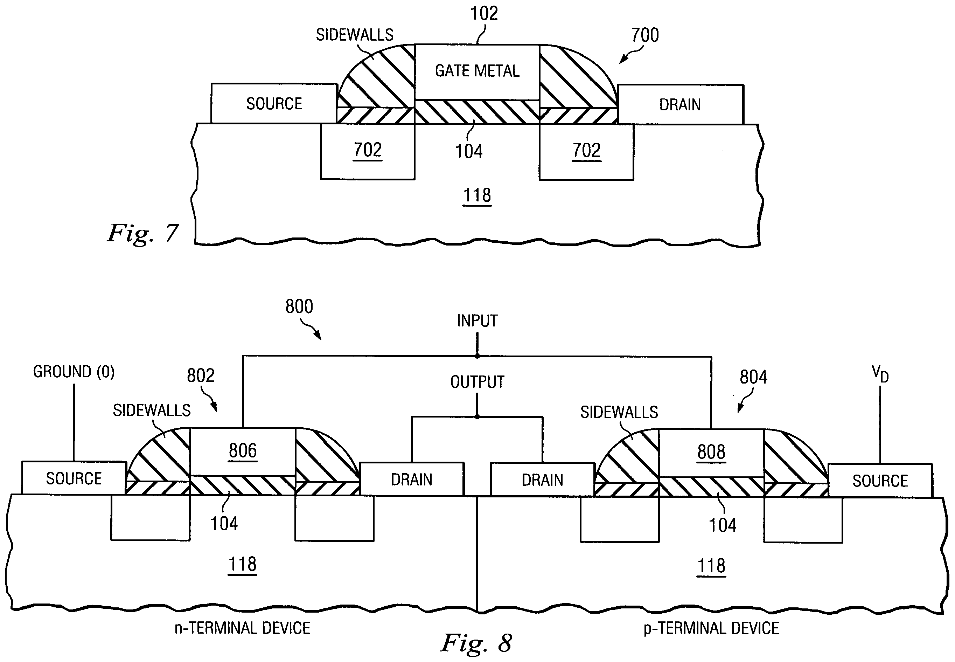

Fig. 7 illustrates a MOSFET 700 fabricated using the layer structure shown in Figs. 1 and 2. The n-type extensions 702 can be implemented using standard means such as ion implantation or virtual channels.

Fig. 8 illustrates a complementary inverter circuit 800 comprising two uni-terminal devices 802, 804, connected in series. The n-terminal device utilizes a gate metal 806 having an effective workfunction Φₘ₁, the p-terminal device employs a gate metal 808 having an effective workfunction Φₘ₂. In one particular embodiment, V_{D} =0.2 V, Φₘ₁= 4.52 eV and Φₘ₂ = 4.72 eV.

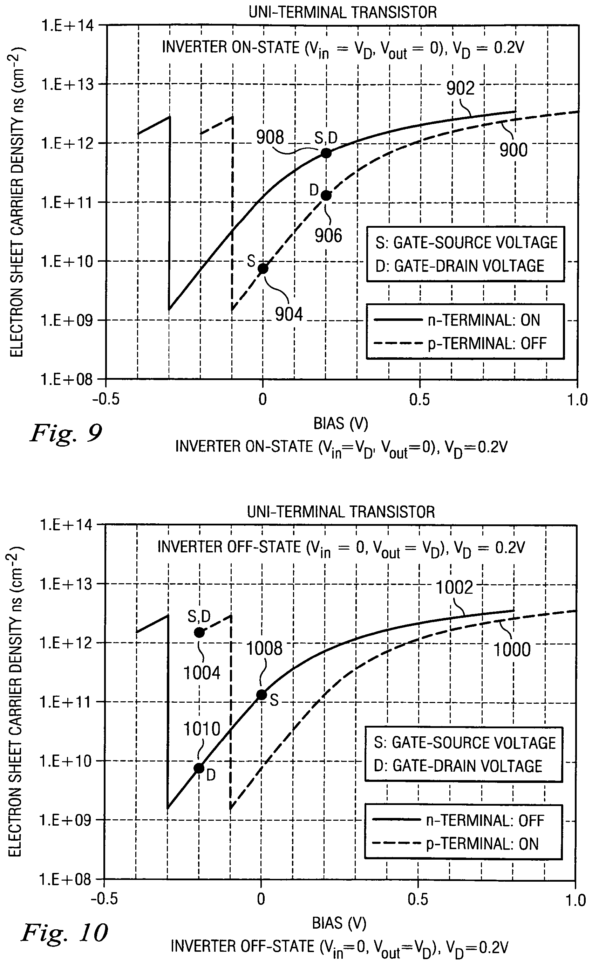

Fig. 9 illustrates channel electron charge vs. input voltage of the p-terminal device 804 (represented by a line 900) and the n-terminal device 802 (represented by a line 902) for the on-state of the inverter circuit 800 (Fig. 8). The gate-source voltage (S) and gate-drain voltage (D) operating points 904, 906, for the p-terminal device, respectively, and gate-source voltage and gate-drain voltage operating point 908 (which is the same for both voltages), for the n-terminal device, respectively, are also shown.

Fig. 10 illustrates channel electron charge vs. input voltage of the p-terminal device 804 (represented by a line 1000) and the n-terminal device 802 (represented by a line 1002) for the off-state of the inverter circuit 800 (Fig. 8). The gate-source voltage and gate-drain voltage operating point 1004 (which is the same for both voltages) for the p-terminal device and gate-source voltage and gate-drain voltage operating points 1008, 1010, for the n-terminal device, respectively, are also shown.

It will be noted that the embodiments described and illustrated herein may be advantageously employed in implementing high performance ("HP"), low operating power ("LOP"), and low standby power ("LSTP") devices. Moreover, all of the transistors described herein may be advantageously implemented in any electronic device and/or circuit that employs one or more transistors.

While the preceding shows and describes one or more embodiments, it will be understood by those skilled in the art that various changes in form and detail may be made therein without departing from the scope of the present disclosure as defined by the appended claims. For example, various steps of the described methods may be executed in a different order or executed sequentially, combined, further divided, replaced with alternate steps, or removed entirely. In addition, various functions illustrated in the methods or described elsewhere in the disclosure may be combined to provide additional and/or alternate functions. Therefore, the claims should be interpreted in a broad manner, consistent with the present disclosure.

### LIST OF EXAMPLES

1. An n-channel transistor having p-terminal characteristics, the n-channel transistor comprising:
   a first semiconductor layer having a discrete hole level H₀;
   a second semiconductor layer having a conduction band minimum E_{C2};
   a wide bandgap semiconductor barrier layer disposed between the first and the second semiconductor layers;
   a gate dielectric layer disposed above the first semiconductor layer; and
   a gate metal layer disposed above the gate dielectric layer and having an effective workfunction selected to position the discrete hole level H₀ below the conduction band minimum E_{c2} for zero bias applied to the gate metal layer and to obtain p-terminal characteristics.
2. The n-channel transistor of example 1 wherein E_{C2}=-4.9 eV.
3. The n-channel transistor of example 1 wherein the effective workfunction is 4.72 eV.
4. The n-channel transistor of example 1 wherein the wide band gap semiconductor barrier layer comprises AlAsSb.
5. The n-channel transistor of example 1 wherein the wide band gap semiconductor barrier layer has a thickness of approximately 2 nm.
6. The n-channel transistor of example 1 wherein the first semiconductor layer comprises GaSb and has a thickness of approximately 2 nm.
7. The n-channel transistor of example 1 wherein the second semiconductor layer comprises InAs and has a thickness of approximately 2 nm.
8. The n-channel transistor of example 1 further comprising:
   a substrate;
   a Fermi level pinning layer disposed on the substrate;
   extensions having n-type conductivity; and
   a wide bandgap buffer layer disposed between the second semiconductor layer and the Fermi level pinning layer.
9. The n-channel transistor of example 8 wherein the wide bandgap semiconductor buffer layer comprises AlAsSb.
10. The n-channel transistor of example 8 wherein a thickness of the wide bandgap semiconductor buffer layer is approximately 20 nm.
11. The n-channel transistor of example 1 wherein the gate metal layer comprises a metal selected from a group consisting of TaN, TiN, W, Ta, Mo, and Ru.
12. The n-channel transistor of example 1 wherein the gate dielectric layer comprises HfO₂.
13. The n-channel transistor of example 8 wherein the Fermi level pinning layer comprises a wide bandgap semiconductor layer with a discrete energy level inside its bandgap.
14. The n-channel transistor of example 8 wherein the Fermi level pinning layer comprises an interface of high defectivity.
15. The n-channel transistor of example 8 wherein the Fermi level pinning layer comprises a Schottky contact having an appropriate barrier height.
16. The n-channel transistor of example 1 wherein an electron density in the second semiconductor layer increases abruptly in response to a negative bias applied to the gate metal layer.
17. An inverter circuit comprising:
   an n-channel transistor with n-terminal characteristics comprising:
      a first semiconductor layer having a first discrete hole level H₀;
      a second semiconductor layer having a conduction band minimum E_{C2};
      a first wide bandgap semiconductor barrier layer disposed between the first and the second semiconductor layers;
      a first gate dielectric layer disposed above the first semiconductor layer;
      a first gate metal layer disposed above the first gate dielectric layer and having a first effective workfunction selected to position the first discrete hole level H₀ below the conduction band minimum E_{c2} for zero bias applied to the first gate metal layer and to obtain n-terminal characteristics; and
      a first set of extensions having n-type conductivity; and
   an n-channel transistor with p-terminal characteristics comprising:
      a third semiconductor layer having a second discrete hole level H₀;
      a fourth semiconductor layer having a conduction band minimum E_{C2};
      a second wide bandgap semiconductor barrier layer disposed between the third and fourth semiconductor layers;
      a second gate dielectric layer disposed above the third semiconductor layer; and
      a second gate metal layer disposed above the second gate dielectric layer and having a second effective workfunction selected to position the second discrete hole level H₀ below the second conduction band minimum E_{c2} for zero bias applied to the second gate metal layer and to obtain p-terminal characteristics; and
      a second set of extensions having n-type conductivity.
18. The inverter circuit of example 17 wherein the conduction band minimum E_{C2}=-4.9 eV.
19. The inverter circuit of example 17 wherein the first effective workfunction is 4.52 eV.
20. The inverter circuit of example 17 wherein the second effective workfunction is 4.72 eV.
21. The inverter circuit of example 17 wherein each of the first and second wide band gap semiconductor barrier layers comprises AlAsSb.
22. The inverter circuit of example 17 wherein each of the first and second wide band gap semiconductor barrier layers is approximately 2 nm thick.
23. The inverter circuit of example 17 wherein each of the first and third semiconductor layers comprises GaSb having a thickness of approximately 2 nm.
24. The inverter circuit of example 17 wherein each of the second and fourth semiconductor layers comprises InAs having a thickness of approximately 2 nm.
25. The inverter circuit of example 17 wherein the n-channel transistor with n-terminal characteristics further comprises:
   a substrate;
   a Fermi level pinning layer disposed on the substrate; and
   a wide bandgap buffer layer disposed between the second semiconductor layer and the Fermi level pinning layer.
26. The inverter circuit of example 25 wherein the wide bandgap semiconductor buffer layer comprises AlAsSb.
27. The inverter circuit of example 25 wherein the wide bandgap semiconductor buffer layer is approximately 20 nm thick.
28. The inverter circuit of example 17 wherein the n-channel transistor with p-terminal characteristics further comprises:
   a substrate;
   a Fermi level pinning layer disposed on the substrate; and
   a wide bandgap buffer layer disposed between the fourth semiconductor layer and the Fermi level pinning layer.
29. The inverter circuit of example 28 wherein the wide bandgap semiconductor buffer layer comprises AlAsSb.
30. The inverter circuit of example 28 wherein the wide bandgap semiconductor buffer layer is approximately 20 nm thick.
31. The inverter circuit of example 17 wherein at least one of the first and second gate metal layers comprises a metal selected from a group consisting of TaN, TiN, W, Ta, Mo, and Ru.
32. The inverter circuit of example 17 wherein the first and second gate dielectric layers comprise HfO₂.
33. The inverter circuit of example 28 wherein the Fermi level pinning layer comprises a wide bandgap semiconductor layer with a discrete energy level inside its bandgap.
34. The inverter circuit of example 28 wherein the Fermi level pinning layer comprises an interface of high defectivity.
35. The inverter circuit of example 28 wherein the Fermi level pinning layer comprises a Schottky contact having an appropriate barrier height.
36. The inverter circuit of example 17 wherein an electron density in the second and fourth semiconductor layers increases abruptly in response to a negative bias applied to the respective gate metal layer.
37. An inverter circuit comprising:
   a first semiconductor layer having a first discrete hole level H₀;
   a second semiconductor layer having a conduction band minimum E_{C2};
   a wide bandgap semiconductor barrier layer disposed between the first and the second semiconductor layers;
   a first gate dielectric layer disposed above the first semiconductor layer;
   a first gate metal layer disposed above the first gate dielectric layer and having a first effective workfunction selected to position the first discrete hole level H₀ below the conduction band minimum E_{c2} for zero bias applied to the first gate metal layer and to obtain n-terminal characteristics;
   a second gate dielectric layer disposed above the first semiconductor layer; and
   a second gate metal layer disposed above the second gate dielectric layer and having a second effective workfunction selected to position the second discrete hole level H₀ below the second conduction band minimum E_{c2} for zero bias applied to the second gate metal layer and to obtain p-terminal characteristics.
38. The inverter circuit of example 37 wherein the conduction band minimum E_{C2}=-4.9 eV.
39. The inverter circuit of example 37 wherein the first effective workfunction is 4.52 eV.
40. The inverter circuit of example 37 wherein the second effective workfunction is 4.72 eV.
41. The inverter circuit of example 37 wherein the wide band gap semiconductor barrier layer comprises AlAsSb.
42. The inverter circuit of example 37 wherein the wide band gap semiconductor barrier layer is approximately 2 nm thick.
43. The inverter circuit of example 37 wherein the first semiconductor layer comprises GaSb having a thickness of approximately 2 nm.
44. The inverter circuit of example 37 wherein the second semiconductor layer comprises InAs having a thickness of approximately 2 nm.
45. The inverter circuit of example 37 further comprising:
   a substrate;
   a Fermi level pinning layer disposed on the substrate; and
   a wide bandgap buffer layer disposed between the second semiconductor layer and the Fermi level pinning layer.
46. The inverter circuit of example 45 wherein the wide bandgap semiconductor buffer layer comprises AlAsSb.
47. The inverter circuit of example 45 wherein the wide bandgap semiconductor buffer layer is approximately 20 nm thick.
48. The inverter circuit of example 37 wherein at least one of the first and second gate metal layers comprises a metal selected from a group consisting of TaN, TiN, W, Ta, Mo, and Ru.
49. The inverter circuit of example 37 wherein the first and second gate dielectric layers comprise HfO₂.
50. The inverter circuit of example 45 wherein the Fermi level pinning layer comprises a wide bandgap semiconductor layer with a discrete energy level inside its bandgap.
51. The inverter circuit of example 45 wherein the Fermi level pinning layer comprises an interface of high defectivity.
52. The inverter circuit of example 45 wherein the Fermi level pinning layer comprises a Schottky contact having an appropriate barrier height.
53. An n-channel transistor having n-terminal characteristics, the n-channel transistor comprising:
   means for providing a layer having a discrete hole level H₀;
   means for providing a layer having a conduction band minimum E_{C2};
   means for providing a wide bandgap barrier between the layer having a discrete hole level H₀ and the layer having a conduction band minimum E_{C2};
   means for providing a dielectric layer above the layer having a discrete hole level Ho; and
   means disposed above the dielectric layer for implementing a gate having an effective workfunction selected to position the discrete hole level H₀ below the conduction band minimum E_{c2} for zero bias applied to the gate metal layer and to obtain n-terminal characteristics.
54. The n-channel transistor of example 53 wherein E_{C2}=-4.9 eV.
55. The n-channel transistor of example 53 wherein the effective workfunction is 4.52 eV.
56. The n-channel transistor of example 53 wherein the means for providing a wide band gap barrier comprises AlAsSb having a thickness of approximately 2 nm.
57. The n-channel transistor of example 53 wherein the means for providing a layer having a discrete hole level H₀ comprises GaSb and has a thickness of approximately 2 nm.
58. The n-channel transistor of example 53 wherein the means for providing a layer having a conduction band minimum E_{C2} comprises InAs and has a thickness of approximately 2 nm.
59. The n-channel transistor of example 53 further comprising:
   a substrate;
   means for achieving Fermi level pinning disposed on the substrate; and
   means for providing a wide bandgap buffer between the layer comprising a conduction band minimum E_{C2} and the means for achieving Fermi level pinning.
60. The n-channel transistor of example 59 wherein the means for providing a wide bandgap buffer comprises AlAsSb having a thickness of approximately 20 nm.
61. The n-channel transistor of example 53 wherein the means for implementing a gate comprises a material selected from a group consisting of TaN, TiN, W, Ta, Mo, and Ru.
62. The n-channel transistor of example 53 wherein the means for implementing a dielectric layer comprises HfO₂.
63. The n-channel transistor of example 59 wherein the means for achieving Fermi level pinning comprises one of a wide bandgap semiconductor layer with a discrete energy level inside its bandgap, an interface of high defectivity, and a Schottky contact having an appropriate barrier height.
64. The n-channel transistor of example 53 wherein an electron density in the means for providing a layer having a conduction band minimum E_{C2} increases abruptly in response to a negative bias applied to the gate.
65. An n-channel transistor having p-terminal characteristics, the n-channel transistor comprising:
   means for providing a layer having a discrete hole level H₀;
   means for providing a layer having a conduction band minimum E_{C2};
   means for providing a wide bandgap barrier between the layer having a discrete hole level H₀ and the layer having a conduction band minimum E_{C2};
   means for providing a dielectric layer above the layer having a discrete hole level H₀; and
   means disposed above the dielectric layer for implementing a gate having an effective workfunction selected to position the discrete hole level H₀ below the conduction band minimum E_{c2} for zero bias applied to the gate metal layer and to obtain p-terminal characteristics.
66. The n-channel transistor of example 65 wherein E_{C2}=-4.9 eV.
67. The n-channel transistor of example 65 wherein the effective workfunction is 4.72 eV.
68. The n-channel transistor of example 65 wherein the means for providing a wide band gap barrier comprises AlAsSb and has a thickness of approximately 2 nm.
69. The n-channel transistor of example 65 wherein the means for providing a layer having a discrete hole level H₀ comprises GaSb and has a thickness of approximately 2 nm.
70. The n-channel transistor of example 65 wherein the means for providing a layer having a conduction band minimum E_{C2} comprises InAs and has a thickness of approximately 2 nm.
71. The n-channel transistor of example 65 further comprising:
   a substrate;
   means for achieving Fermi level pinning disposed on the substrate; and
   means for providing a wide bandgap buffer between the layer comprising a conduction band minimum E_{C2} and the means for achieving Fermi level pinning.
72. The n-channel transistor of example 71 wherein the means for providing a wide bandgap buffer comprises AlAsSb and has a thickness of approximately 20 nm.
73. The n-channel transistor of example 65 wherein the means for implementing a gate comprises a material selected from a group consisting of TaN, TiN, W, Ta, Mo, and Ru.
74. The n-channel transistor of example 65 wherein the means for implementing a dielectric layer comprises HfO₂.
75. The n-channel transistor of example 71 wherein the means for achieving Fermi level pinning comprises one of a wide bandgap semiconductor layer with a discrete energy level inside its bandgap, an interface of high defectivity, and a Schottky contact having an appropriate barrier height.
76. The n-channel transistor of example 65 wherein an electron density in the means for providing a layer having a conduction band minimum E_{C2} increases abruptly in response to a negative bias applied to the gate.
77. An inverter circuit comprising:
   means for implementing a layer having a discrete hole level H₀;
   means for implementing a layer having a conduction band minimum E_{C2};
   means for implementing a wide bandgap barrier between the layer having a first discrete hole level H₀ and the layer having a conduction band minimum E_{C2};
   means for implementing a first dielectric layer above the layer having a discrete hole level H₀;
   means for implementing a first gate above the first dielectric layer having a first effective workfunction selected to position the first discrete hole level H₀ below the conduction band minimum E_{c2} for zero bias applied to the first gate and to obtain n-terminal characteristics;
   means for implementing a second dielectric layer above the layer having a discrete hole level H₀; and
   means for implementing a second gate above the second gate dielectric layer having a second effective workfunction selected to position the second discrete hole level H₀ below the second conduction band minimum E_{c2} for zero bias applied to the second gate and to obtain p-terminal characteristics.
78. The inverter circuit of example 77 wherein the conduction band minimum E_{C2}=-4.9 eV.
79. The inverter circuit of example 77 wherein the first effective workfunction is 4.52 eV.
80. The inverter circuit of example 77 wherein the second effective workfunction is 4.72 eV.
81. The inverter circuit of example 77 wherein the first semiconductor layer comprises GaSb having a thickness of approximately 2 nm.
82. The inverter circuit of example 77 wherein the second semiconductor layer comprises InAs having a thickness of approximately 2 nm.
83. The inverter circuit of example 77 further comprising:
   a substrate;
   a Fermi level pinning layer disposed on the substrate; and
   a wide bandgap buffer layer disposed between the second semiconductor layer and the Fermi level pinning layer.
84. The inverter circuit of example 83 wherein at least one of the means for implementing a wide bandgap barrier and the means for implementing a wide bandgap buffer comprises AlAsSb.
85. The inverter circuit of example 83 wherein the means for implementing a wide bandgap barrier is approximately 2 nm thick and the means for implementing a wide bandgap buffer layer is approximately 20 nm thick.
86. The inverter circuit of example 77 wherein at least one of means for implementing a first gate and means for implementing a second gate comprises a metal selected from a group consisting of TaN, TiN, W, Ta, Mo, and Ru.
87. The inverter circuit of example 77 wherein the means for implementing a first dielectric layer and the means for implementing a second dielectric layer comprise HfO₂.
88. The inverter circuit of example 83 wherein the means for implementing a Fermi level pinning layer comprises one of a wide bandgap semiconductor layer with a discrete energy level inside its bandgap, an interface of high defectivity, and a Schottky contact having an appropriate barrier height.
89. A device including an n-channel transistor comprising:
   a first semiconductor layer having a discrete hole level H₀;
   a second semiconductor layer having a conduction band minimum E_{C2};
   a wide bandgap semiconductor barrier layer disposed between the first and the second semiconductor layers;
   a gate dielectric layer disposed above the first semiconductor layer; and
   a gate metal layer disposed above the gate dielectric layer and having an effective workfunction selected to position the discrete hole level H₀ below the conduction band minimum E_{c2} for zero bias applied to the gate metal layer and to obtain n-terminal characteristics.
90. The device of example 89 wherein E_{C2}=-4.9 eV.
91. The device of example 89 wherein the effective workfunction is 4.52 eV.
92. The device of example 89 wherein the wide band gap semiconductor barrier layer comprises AlAsSb having a thickness of approximately 2 nm.
93. The device of example 89 wherein the first semiconductor layer comprises GaSb and has a thickness of approximately 2 nm.
94. The device of example 89 wherein the second semiconductor layer comprises InAs and has a thickness of approximately 2 nm.
95. The device of example 89 further comprising:
   a substrate;
   a Fermi level pinning layer disposed on the substrate;
   extensions having n-type conductivity; and
   a wide bandgap buffer layer disposed between the second semiconductor layer and the Fermi level pinning layer.
96. The device of example 95 wherein the wide bandgap semiconductor buffer layer comprises AlAsSb having a thickness of approximately 20 nm.
97. The device of example 89 wherein the gate metal layer comprises a metal selected from a group consisting of TaN, TiN, W, Ta, Mo, and Ru.
98. The device of example 89 wherein the gate dielectric layer comprises HfO₂.
99. The device of example 95 wherein the Fermi level pinning layer comprises one of a wide bandgap semiconductor layer with a discrete energy level inside its bandgap, an interface of high defectivity, and a Schottky contact having an appropriate barrier height.
100. The device of example 89 wherein an electron density in the second semiconductor layer increases abruptly in response to a negative bias applied to the gate metal layer.
101. The device of example 89 wherein the device is at least one of a low operating power ("LOP") device, a high performance ("HP") device, and a low standby power ("LSTP") device.
102. A device including an n-channel transistor comprising:
   a first semiconductor layer having a discrete hole level H₀;
   a second semiconductor layer having a conduction band minimum E_{C2};
   a wide bandgap semiconductor barrier layer disposed between the first and the second semiconductor layers;
   a gate dielectric layer disposed above the first semiconductor layer; and
   a gate metal layer disposed above the gate dielectric layer and having an effective workfunction selected to position the discrete hole level H₀ below the conduction band minimum E_{c2} for zero bias applied to the gate metal layer and to obtain p-terminal characteristics.
103. The device of example 102 wherein E_{C2}=-4.9 eV.
104. The device of example 102 wherein the effective workfunction is 4.72 eV.
105. The device of example 102 wherein the wide band gap semiconductor barrier layer comprises AlAsSb and has a thickness of approximately 2 nm.
106. The device of example 102 wherein the first semiconductor layer comprises GaSb and has a thickness of approximately 2 nm.
107. The device of example 102 wherein the second semiconductor layer comprises InAs and has a thickness of approximately 2 nm.
108. The device of example 102 further comprising:
   a substrate;
   a Fermi level pinning layer disposed on the substrate;
   extensions having n-type conductivity; and
   a wide bandgap buffer layer disposed between the second semiconductor layer and the Fermi level pinning layer.
109. The device of example 108 wherein the wide bandgap semiconductor buffer layer comprises AlAsSb and has a thickness of approximately 20 nm.
110. The device of example 102 wherein the gate metal layer comprises a metal selected from a group consisting of TaN, TiN, W, Ta, Mo, and Ru.
111. The device of example 102 wherein the gate dielectric layer comprises HfO₂.
112. The device of example 108 wherein the Fermi level pinning layer comprises one of a wide bandgap semiconductor layer with a discrete energy level inside its bandgap, an interface of high defectivity, and a Schottky contact having an appropriate barrier height.
113. The device of example 102 wherein an electron density in the second semiconductor layer increases abruptly in response to a negative bias applied to the gate metal layer.
114. The device of example 102 wherein the device is at least one of a low operating power ("LOP") device, a high performance ("HP") device, and a low standby power ("LSTP") device.
115. A device including an inverter circuit comprising:
   a first semiconductor layer having a first discrete hole level H₀;
   a second semiconductor layer having a conduction band minimum E_{C2};
   a wide bandgap semiconductor barrier layer disposed between the first and the second semiconductor layers;
   a first gate dielectric layer disposed above the first semiconductor layer;
   a first gate metal layer disposed above the first gate dielectric layer and having a first effective workfunction selected to position the first discrete hole level H₀ below the conduction band minimum E_{c2} for zero bias applied to the first gate metal layer and to obtain n-terminal characteristics;
   a second gate dielectric layer disposed above the first semiconductor layer; and
   a second gate metal layer disposed above the second gate dielectric layer and having a second effective workfunction selected to position the second discrete hole level H₀ below the second conduction band minimum E_{c2} for zero bias applied to the second gate metal layer and to obtain p-terminal characteristics.
116. The inverter circuit of example 115 wherein the conduction band minimum E_{C2}=-4.9 eV.
117. The inverter circuit of example 115 wherein the first effective workfunction is 4.52 eV.
118. The inverter circuit of example 115 wherein the second effective workfunction is 4.72 eV.
119. The inverter circuit of example 115 wherein the wide band gap semiconductor barrier layer comprises AlAsSb and has a thickness of approximately 2 nm.
120. The inverter circuit of example 115 wherein the first semiconductor layer comprises GaSb having a thickness of approximately 2 nm.
121. The inverter circuit of example 115 wherein the second semiconductor layer comprises InAs having a thickness of approximately 2 nm.
122. The inverter circuit of example 115 further comprising:
   a substrate;
   a Fermi level pinning layer disposed on the substrate; and
   a wide bandgap buffer layer disposed between the second semiconductor layer and the Fermi level pinning layer.
123. The inverter circuit of example 122 wherein the wide bandgap semiconductor buffer layer comprises AlAsSb and has a thickness of approximately 20 nm.
124. The inverter circuit of example 115 wherein at least one of the first and second gate metal layers comprises a metal selected from a group consisting of TaN, TiN, W, Ta, Mo, and Ru.
125. The inverter circuit of example 115 wherein the first and second gate dielectric layers comprise HfO₂.
126. The inverter circuit of example 122 wherein the Fermi level pinning layer comprises one of a wide bandgap semiconductor layer with a discrete energy level inside its bandgap, an interface of high defectivity, and a Schottky contact having an appropriate barrier height.
127. The device of example 115 wherein the device is at least one of a low operating power ("LOP") device, a high performance ("HP") device, and a low standby power ("LSTP") device.

## Claims

1. An inverter circuit (800), comprising:
- a first n-channel transistor (802) with n-terminal characteristics, comprising:
- a first semiconductor layer (106, 118) having a first discrete hole level H₀;
- a second semiconductor layer (110, 118) having a first conduction band minimum E_{C2};
- a first wide bandgap semiconductor barrier layer (108, 118) disposed between the first and the second semiconductor layers (106, 110);
- a first gate dielectric layer (104) disposed above the first semiconductor layer (106, 118);
- a first gate metal layer (806) disposed above the first gate dielectric layer (104) and having a first effective workfunction selected to position the first discrete hole level H₀ below the first conduction band minimum E_{c2} for zero bias applied to the first gate metal layer (806) and to obtain n-terminal characteristics_in which the first n-channel transistor (802) turns on when the bias applied to the first gate metal layer (806) is increased above 0V to a first positive threshold voltage,
wherein the first and second semiconductor layers (106, 118, 110, 118) and the first wide bandgap semiconductor barrier layer (108, 118) are selected such that a hybrid state with a wavefunction in the first and second semiconductor layers (106, 118, 110, 118) is formed at a bias applied to the first gate metal layer (806) being equal to a second negative threshold voltage; and
a first set of extensions (SOURCE, DRAIN) having n-type conductivity; and
- a second n-channel transistor (804) with p-terminal characteristics, comprising:
- a third semiconductor layer (106, 118) having a second discrete hole level H₀;
- a fourth semiconductor layer (110, 118) having a second conduction band minimum E_{C2};
- a second wide bandgap semiconductor barrier layer (108, 118) disposed between the third and the fourth semiconductor layers (106, 110);
- a second gate dielectric layer (104) disposed above the third semiconductor layer (106, 118); and
- a second gate metal layer (808) disposed above the second gate dielectric layer (104) and having a second effective workfunction, different from the first effective workfunction, selected to position the second discrete hole level H₀ below the second conduction band minimum E_{c2} for zero bias applied to the second gate metal layer (808) and to obtain p-terminal characteristics in which the second n-channel transistor (804) turns on when the bias applied to the second gate metal layer (808) is lowered below 0V to the second negative threshold voltage,
wherein the third and fourth semiconductor layers (106, 118, 110, 118) and the second wide bandgap semiconductor barrier layer (108, 118) are selected such that a hybrid state with a wavefunction in the third and fourth semiconductor layers (106, 118, 110, 118) is formed at a bias applied to the second gate metal layer (808) being equal to the second negative threshold voltage; and
- a second set of extensions (SOURCE, DRAIN) having n-type conductivity.

2. The inverter circuit (800) of claim 1, wherein E_{C2}=-4.9 eV.

3. The inverter circuit (800) of claim 1, wherein the first effective workfunction is 4.52 eV and the second effective workfunction is 4.72 eV.

4. The inverter circuit (800) of claim 1, wherein the first and second wide band gap semiconductor barrier layers (108, 118) comprise AlAsSb.

5. The inverter circuit (800) of claim 1, wherein the first and second wide band gap semiconductor barrier layers (108, 118) have each a thickness of approximately 2 nm.

6. The n inverter circuit (800) of claim 1, wherein the first and third semiconductor layers (106, 118) comprise GaSb and have each a thickness of approximately 2 nm.

7. The inverter circuit (800) of claim 1, wherein the second and fourth semiconductor layers (110, 118) comprise InAs and have each a thickness of approximately 2 nm.

8. The inverter circuit (800) of claim 1, wherein the first n-channel transistor (802) comprises:
- a substrate (116);
- a Fermi level pinning layer (114) disposed on the substrate (116); and
- a wide bandgap semiconductor buffer layer (112) disposed between the second semiconductor layer (110) and the Fermi level pinning layer (114).

9. The inverter circuit (800) of claim 8, wherein the wide bandgap semiconductor buffer layer (112) comprises AlAsSb.

10. The inverter circuit (800) of claim 8, wherein a thickness of the wide bandgap semiconductor buffer layer (112) is approximately 20 nm.

11. The inverter circuit (800) of claim 1, wherein each of the first and second gate metal layers (806, 808) comprises a metal selected from a group consisting of TaN, TiN, W, Ta, Mo, and Ru.

12. The inverter circuit (800) of claim 1, wherein each of the first and second gate dielectric layers (104) comprises HfO₂.

13. The inverter circuit (800) of claim 8, wherein the Fermi level pinning layer (114) comprises a wide bandgap semiconductor layer with a discrete energy level inside its bandgap.

14. The inverter circuit (800) of claim 8, wherein the Fermi level pinning layer (447) comprises an interface of high defectiveity.

## Patentansprüche

1. Wechselrichterschaltung (800), die Folgendes umfasst:
- einen ersten n-Kanal-Transistor (802) mit n-Anschluss-Eigenschaften, der Folgendes umfasst:
- eine erste Halbleiterschicht (106, 118) mit einem ersten diskreten Lochniveau H₀;
- eine zweite Halbleiterschicht (110, 118) mit einem ersten Leitungsbandminimum E_{C2};
- eine erste Barrierenschicht eines Halbleiters mit breiter Bandlücke (108, 118), die zwischen der ersten und der zweiten Halbleiterschicht (106, 110) angeordnet ist;
- eine erste Gate-Dielektrikumschicht (104), die über der ersten Halbleiterschicht (106, 118) angeordnet ist;
- eine erste Gate-Metallschicht (806), die über der ersten Gate-Dielektrikumschicht (104) angeordnet ist und eine erste effektive Austrittsarbeit besitzt, die ausgewählt ist, das erste diskrete Lochniveau H₀ für eine an die erste Gate-Metallschicht (806) angelegte Nullvorspannung unter dem ersten Leitungsbandminimum E_{C2} zu positionieren und n-Anschluss-Eigenschaften zu erhalten, wobei der erste n-Kanal-Transistor (802) durchschaltet, wenn die an die erste Gate-Metallschicht (806) angelegte Spannung über 0 V auf eine erste positive Schwellenspannung erhöht wird,
wobei die erste und die zweite Halbleiterschicht (106, 118, 110, 118) und die erste Barrierenschicht eines Halbleiters mit breiter Bandlücke (108, 118) so gewählt sind, dass ein Hybridzustand mit einer Wellenfunktion in der ersten und in der zweiten Halbleiterschicht (106, 118, 110, 118) bei einer an die erste Gate-Metallschicht (806) angelegten Spannung, die gleich einer zweiten negativen Schwellenspannung ist, gebildet wird; und
eine erste Gruppe von Erweiterungen (SOURCE, DRAIN) mit n-Typ-Leitfähigkeit; und
- einen zweiten n-Kanal-Transistor (804) mit p-Anschluss-Eigenschafen, der Folgendes umfasst:
- eine dritte Halbleiterschicht (106, 118) mit einem zweiten diskreten Lochniveau H₀;
- eine vierte Halbleiterschicht (110, 118) mit einem zweiten Leitungsbandminimum E_{C2};
- eine zweite Barrierenschicht eines Halbleiters mit breiter Bandlücke (108, 118), die zwischen der dritten und der vierten Halbleiterschicht (106, 110) angeordnet ist;
- eine zweite Gate-Dielektrikumschicht (104), die über der dritten Halbleiterschicht (106, 118) angeordnet ist; und
- eine zweite Gate-Metallschicht (808), die über der zweiten Gate-Dielektrikumschicht (104) angeordnet ist und eine zweite effektive Austrittsarbeit besitzt, die von der ersten effektiven Austrittsarbeit verschieden ist und die so gewählt ist, das zweite diskrete Lochniveau H₀ für eine an die zweite Gate-Metallschicht (808) angelegte Nullvorspannung unter dem zweiten Leitungsbandminimum E_{C2} zu positionieren und p-Anschluss-Eigenschaften zu erhalten, wobei der zweite n-Kanal-Transistor (804) durchschaltet, wenn die an die zweite Gate-Metallschicht (808) angelegte Spannung unter 0 V auf die zweite negative Schwellenspannung gesenkt wird,
wobei die dritte und die vierte Halbleiterschicht (106, 118, 110, 118) und die zweite Barrierenschicht eines Halbleiters mit breiter Bandlücke (108, 118) so gewählt sind, dass ein Hybridzustand mit einer Wellenform in der dritten und der vierten Halbleiterschicht (106, 118, 110, 118) bei einer an die zweite Gate-Metallschicht (808) angelegten Spannung, die gleich der zweiten negativen Schwellenspannung ist, gebildet wird; und
- eine zweite Gruppe von Erweiterungen (SOURCE, DRAIN) mit einer n-Typ-Leitfähigkeit.

2. Wechselrichterschaltung (800) nach Anspruch 1, wobei E_{C2} = -4,9 eV ist.

3. Wechselrichterschaltung (800) nach Anspruch 1, wobei die erste effektive Austrittsarbeit 4,52 eV beträgt und die zweite effektive Austrittsarbeit 4,72 eV beträgt.

4. Wechselrichterschaltung (800) nach Anspruch 1, wobei die erste und die zweite Barrierenschicht eines Halbleiters mit breiter Bandlücke (108, 118) AlAsSb umfassen.

5. Wechselrichterschaltung (800) nach Anspruch 1, wobei die erste und die zweite Barrierenschicht eines Halbleiters mit breiter Bandlücke (108, 118) jeweils eine Dicke von ungefähr 2 nm aufweisen.

6. Wechselrichterschaltung (800) nach Anspruch 1, wobei die erste und die dritte Halbleiterschicht (106, 118) GaSb umfassen und jeweils eine Dicke von ungefähr 2 nm aufweisen.

7. Wechselrichterschaltung (800) nach Anspruch 1, wobei die zweite und die vierte Halbleiterschicht (110, 118) InAs umfassen und jeweils eine Dicke von ungefähr 2 nm aufweisen.

8. Wechselrichterschaltung (800) nach Anspruch 1, wobei der erste n-Kanal-Transistor (802) umfasst:
- ein Substrat (116);
- eine Fermi-Niveau-Pinning-Schicht (114), die auf dem Substrat (116) angeordnet ist; und
- eine Pufferschicht eines Halbleiters mit breiter Bandlücke (112), die zwischen der zweiten Halbleiterschicht (110) und der Fermi-Niveau-Pinning-Schicht (114) angeordnet ist.

9. Wechselrichterschaltung (800) nach Anspruch 8, wobei die Pufferschicht eines Halbleiters mit breiter Bandlücke (112) AlAsSb umfasst.

10. Wechselrichterschaltung (800) nach Anspruch 8, wobei eine Dicke der Pufferschicht eines Halbleiters mit breiter Bandlücke (112) ungefähr 20 nm beträgt.

11. Wechselrichterschaltung (800) nach Anspruch 1, wobei jede der ersten und der zweiten Gate-Metallschicht (806, 808) ein Metall umfasst, das aus einer Gruppe ausgewählt ist, die aus TaN, TiN, W, Ta, Mo und Ru besteht.

12. Wechselrichterschaltung (800) nach Anspruch 1, wobei jede der ersten und der zweiten Gate-Dielektrikumschicht (104) HfO₂ umfasst.

13. Wechselrichterschaltung (800) nach Anspruch 8, wobei die Fermi-Niveau-Pinning-Schicht (114) eine Schicht eines Halbleiters mit breiter Bandlücke mit einem diskreten Energieniveau innerhalb seiner Bandlücke umfasst.

14. Wechselrichterschaltung (800) nach Anspruch 8, wobei die Fermi-Niveau-Pinning-Schicht (447) eine Schnittstelle einer hohen Defektrate umfasst.

## Revendications

1. Circuit inverseur (800) comprenant :
- un premier transistor à canal n (802) avec des caractéristiques de terminal n, comprenant :
- une première couche semiconductrice (106, 118) présentant un premier niveau d'orifices discrets H₀ ;
- une deuxième couche semiconductrice (110, 118) présentant un premier minimum de bande de conduction E_{C2} ;
- une première couche barrière semiconductrice à bande interdite large (108, 118) disposée entre les première et deuxième couches semiconductrices (106, 110) ;
- une première couche diélectrique de grille (104) disposée sur la première couche semiconductrice (106, 110) ;
- une première couche métallique de grille (806) disposée sur la première couche diélectrique de grille (104) et présentant une première fonction de travail effective sélectionnée pour positionner le premier niveau d'orifices discrets H₀ en dessous du premier minimum de bande de conduction E_{C2} pour une polarisation nulle appliquée à la première couche métallique de grille (806), et pour obtenir des caractéristiques de terminal n dans lesquelles le premier transistor à canal n (802) s'allume lorsque la polarisation appliquée à la première couche métallique de grille (806) est augmentée au-dessus de 0V à une première tension seuil positive,
où les première et deuxième couches semiconductrices (106, 118, 110, 118) et la première couche barrière semiconductrice à bande interdite large (108, 118) sont sélectionnées de manière à ce qu'un état hybride avec une fonction d'onde dans les première et deuxième couches semiconductrices (106, 118, 110, 118) soit établi à une polarisation appliquée à la première couche métallique de grille (806) étant égale à une deuxième tension seuil négative ; et
un premier ensemble d'extensions (SOURCE, DRAIN) présentant une conductivité du type n ; et
- un deuxième transistor à canal n (804) avec des caractéristiques de terminal p, comprenant :
- une troisième couche semiconductrice (106, 118) présentant un deuxième niveau d'orifices discrets H₀ ;
- une quatrième couche semiconductrice (110, 118) présentant un deuxième minimum de bande de conduction E_{C2} ;
- une deuxième couche barrière semiconductrice à bande interdite large (108, 118) disposée entre les troisième et quatrième couches semiconductrices (106, 110) ;
- une deuxième couche diélectrique de grille (104) disposée sur la troisième couche semiconductrice (106, 118) ; et
- une deuxième couche métallique de grille (808) disposée sur la deuxième couche diélectrique de grille (104) et présentant une deuxième fonction de travail effective différente de la première fonction de travail effective, sélectionnée pour positionner le deuxième niveau d'orifices discrets H₀ en dessous du deuxième minimum de bande de conduction E_{C2} pour une polarisation zéro appliquée à la deuxième couche métallique de grille (808), et pour obtenir des caractéristiques de terminal p dans lesquelles le deuxième transistor de canal n (804) s'allume lorsque la polarisation appliquée à la deuxième couche métallique de grille (808) est diminuée en dessous de 0V à la deuxième tension seuil négative,
où les troisième et quatrième couches semiconductrices (106, 118, 110, 118) et la deuxième couche barrière semiconductrice à bande interdite large (108, 118) sont sélectionnées de manière à ce qu'un état hybride avec une fonction d'onde dans les troisième et quatrième couches semiconductrices (106, 118, 110, 118) soit établi à une polarisation appliquée à la deuxième couche métallique de grille (808) étant égale à la deuxième tension seuil négative ; et
- un deuxième ensemble d'extensions (SOURCE, DRAIN) présentant une conductivité du type n.

2. Circuit inverseur (800) selon la revendication 1, dans lequel E_{C2} = 4,9 eV.

3. Circuit inverseur (800) selon la revendication 1, dans lequel la première fonction de travail effective est de 4,52 eV et la deuxième fonction de travail effective est de 4,72 eV.

4. Circuit inverseur (800) selon la revendication 1, dans lequel les première et deuxième couches barrières semiconductrices à bande interdite large (108, 118) comprennent de l'AlAsSb.

5. Circuit inverseur (800) selon la revendication 1, dans lequel les première et deuxième couches barrières semiconductrices à bande interdite large (108, 118) présentent respectivement une épaisseur d'environ 2 nm.

6. Circuit inverseur (800) selon la revendication 1, dans lequel les première et deuxième couches semiconductrices (106, 118) comprennent du GaSb et présentent respectivement une épaisseur d'environ 2 nm.

7. Circuit inverseur (800) selon la revendication 1, dans lequel les deuxième et quatrième couches semiconductrices (110, 118) comprennent de l'InAs et présentent respectivement une épaisseur d'environ 2 nm.

8. Circuit inverseur (800) selon la revendication 1, dans lequel le premier transistor à canal n (802) comprend :
- un substrat (116) ;
- une couche d'ancrage de niveau Fermi (114) disposée sur le substrat (116) ; et
- une couche tampon semiconductrice à bande interdite large (112) disposée entre la deuxième couche semiconductrice (110) et la couche d'ancrage de niveau Fermi (114).

9. Circuit inverseur (800) selon la revendication 8, dans lequel la couche tampon semiconductrice à bande interdite large (112) comprend de l'AlAsSb.

10. Circuit inverseur (800) selon la revendication 8, dans lequel une épaisseur de la couche tampon semiconductrice à bande interdite large (112) mesure environ 20 nm.

11. Circuit inverseur (800) selon la revendication 1, dans lequel chacune parmi les première et deuxième couches métalliques de grille (806, 808) comprend un métal sélectionné à partir d'un groupe comprenant le TaN, le TiN, le W, le Ta, le Mo et le Ru.

12. Circuit inverseur (800) selon la revendication 1, dans lequel chacune parmi les première et deuxième couches diélectriques de grille (104) comprennent du HfO₂.

13. Circuit inverseur (800) selon la revendication 8, dans lequel la couche d'ancrage de niveau Fermi (114) comprend une couche semiconductrice à bande interdite large avec un niveau d'énergie discret à l'intérieur de sa bande interdite.

14. Circuit inverseur (800) selon la revendication 8, dans lequel la couche d'ancrage de niveau Fermi (447) comprend une interface avec une forte défectivité.
